(19) Europäisches Patentamt / European Patent Office / Office européen des brevets

(11) **EP 4 660 701 A1**

(12) **EUROPEAN PATENT APPLICATION**

(43) Date of publication:
**10.12.2025 Bulletin 2025/50**

(21) Application number: 24179978.2

(22) Date of filing: **04.06.2024**

(51) International Patent Classification (IPC):
*G03F 7/00* $^{(2006.01)}$    *G03F 9/00* $^{(2006.01)}$

(52) Cooperative Patent Classification (CPC):
**G03F 7/70525; G03F 9/7019; G03F 9/7092**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicant: **ASML Netherlands B.V.**
**5500 AH Veldhoven (NL)**

(72) Inventors:
• **NAGASSA DHARMA, Radius**
  **5500 AH Veldhoven (NL)**
• **DUMAN, Özer**
  **5500 AH Veldhoven (NL)**

• **ISSA, Hamze**
  **5500 AH Veldhoven (NL)**
• **ROSTAMI, Hamideh**
  **5500 AH Veldhoven (NL)**
• **CARBONE, Ludovico**
  **5500 AH Veldhoven (NL)**
• **CALLE ARIZMENDIARRIETA, Mikel, Calle**
  **5500 AH Veldhoven (NL)**

(74) Representative: **ASML Netherlands B.V.**
**Corporate Intellectual Property**
**P.O. Box 324**
**5500 AH Veldhoven (NL)**

Remarks:
Claims 16-25 are deemed to be abandoned due to non-payment of the claims fees (Rule 45(3) EPC).

(54) **METHOD OF DETERMINING DEGRADATION ON A SENSOR FIDUCIAL**

(57) Disclosed is a method of determining a fiducial degradation metric for a sensor fiducial. The method comprises obtaining fiducial plane position data describing a position over a time period, and in a fiducial plane, of a plurality of marks on a fiducial surface; determining first fiducial position drift data from the fiducial plane position data, said first fiducial position drift data describing a temporal drift in measured positions within the fiducial plane position data; obtaining height data describing a position over said time period, and perpendicular to the fiducial plane, of the fiducial surface; determining second fiducial position drift data from said height data; and determining the fiducial degradation metric from said first fiducial position drift data and said second fiducial position drift data.

Fig. 4

## Description

BACKGROUND

The present invention relates to methods and apparatus usable, for example, in the manufacture of devices by lithographic techniques, and to methods of manufacturing devices using lithographic techniques.

FIELD OF THE INVENTION

A lithographic apparatus is a machine that applies a desired pattern onto a substrate, usually onto a target portion of the substrate. A lithographic apparatus can be used, for example, in the manufacture of integrated circuits (ICs). In that instance, a patterning device, which is alternatively referred to as a mask or a reticle, may be used to generate a circuit pattern to be formed on an individual layer of the IC. This pattern can be transferred onto a target portion (e.g. including part of a die, one die, or several dies) on a substrate (e.g., a silicon wafer). Transfer of the pattern is typically via imaging onto a layer of radiation-sensitive material (resist) provided on the substrate. In general, a single substrate will contain a network of adjacent target portions that are successively patterned. These target portions are commonly referred to as "fields".

In the manufacture of complex devices, typically many lithographic patterning steps are performed, thereby forming functional features in successive layers on the substrate. A critical aspect of performance of the lithographic apparatus is therefore the ability to place the applied pattern correctly and accurately in relation to features laid down (by the same apparatus or a different lithographic apparatus) in previous layers. For this purpose, the substrate is provided with one or more sets of alignment marks. Each mark is a structure whose position can be measured at a later time using a position sensor, typically an optical position sensor. The lithographic apparatus includes one or more alignment sensors by which positions of marks on a substrate can be measured accurately. Different types of marks and different types of alignment sensors are known from different manufacturers and different products of the same manufacturer.

In other applications, metrology sensors are used for measuring exposed structures on a substrate (either in resist and/or after etch). A fast and non-invasive form of specialized inspection tool is a scatterometer in which a beam of radiation is directed onto a target on the surface of the substrate and properties of the scattered or reflected beam are measured. Examples of known scatterometers include angle-resolved scatterometers of the type described in US2006033921A1 and US2010201963A1. In addition to measurement of feature shapes by reconstruction, diffraction based overlay can be measured using such apparatus, as described in published patent application US2006066855A1. Diffraction-based overlay metrology using dark-field imaging of the diffraction orders enables overlay measurements on smaller targets. Examples of dark field imaging metrology can be found in international patent applications WO 2009/078708 and WO 2009/106279 which documents are hereby incorporated by reference in their entirety. Further developments of the technique have been described in published patent publications US20110027704A, US20110043791A, US2011102753A1, US20120044470A, US20120123581A, US20130258310A, US20130271740A and WO2013178422A1. These targets can be smaller than the illumination spot and may be surrounded by product structures on a wafer. Multiple gratings can be measured in one image, using a composite grating target. The contents of all these applications are also incorporated herein by reference.

A known lithographic apparatus or "scanner" may comprise a measurement side and an exposure side. At the measurement side, the position of marks on the wafer may be measured relative to a common reference or fiducial. At the expose side, the position and shape of the reticle is measured relative to the fiducial. In this manner, a common reference frame between measure side and expose side is established. Thus reference frame may be used to align the measure side wafer measurements to the required expose side exposure actuations.

The methods and/or locations for performing measurements on the fiducial respectively at the measure side and exposure side are different. Because of this difference, some errors (e.g., resultant from degradation of the fiducial) are only seen by the measure side and not by exposure side and vice versa. Examples of errors seen only by the measure side, are those due to degradation of a fiducial plate (e.g., degradation of the marks on the fiducial plate) of a sensor. As the exposure side uses the measurement side measurements as reference, it cannot correct for these errors, which it is unable to measure, and as such these errors will be seen in the exposure on the wafer.

It would be desirable to determine a metric for the degradation health of the fiducial plate (including the marks thereon).

SUMMARY OF THE INVENTION

The invention in a first aspect provides a method of determining a fiducial degradation metric for a sensor fiducial, the method comprising: obtaining fiducial plane position data describing a position over a time period, and in a fiducial plane, of a plurality of marks on a fiducial surface; determining first fiducial position drift data from the fiducial plane position data, said first fiducial position drift data describing a temporal drift in measured positions within the fiducial plane position data; obtaining height data describing a position over said time period, and perpendicular to the fiducial plane, of the fiducial surface; determining second fiducial position drift data from said height data; and determining the fiducial degradation metric from said first fiducial position drift data and said second fiducial position drift data.

Also disclosed is a computer program and lithographic or exposure apparatus being operable to perform the method of the first aspect.

The above and other aspects of the invention will be understood from a consideration of the examples described below.

BRIEF DESCRIPTION OF THE DRAWINGS

Embodiments of the invention will now be described, by way of example only, with reference to the accompanying drawings, in which:

Figure 1 depicts a lithographic apparatus;
Figure 2 illustrates schematically measurement and exposure processes in the apparatus of Figure 1;
Figure 3 illustrates a mark arrangement on a fiducial, and the effect of a measurement error of a mark due to fiducial degradation;
Figure 4 illustrates how levelling data and alignment data may be combined to determine a fiducial degradation metric; and
Figure 5 is a flowchart describing a method of determining a fiducial degradation metric according to a concepts disclosed herein.

DETAILED DESCRIPTION OF EMBODIMENTS

Before describing embodiments of the invention in detail, it is instructive to present an example environment in which embodiments of the present invention may be implemented.

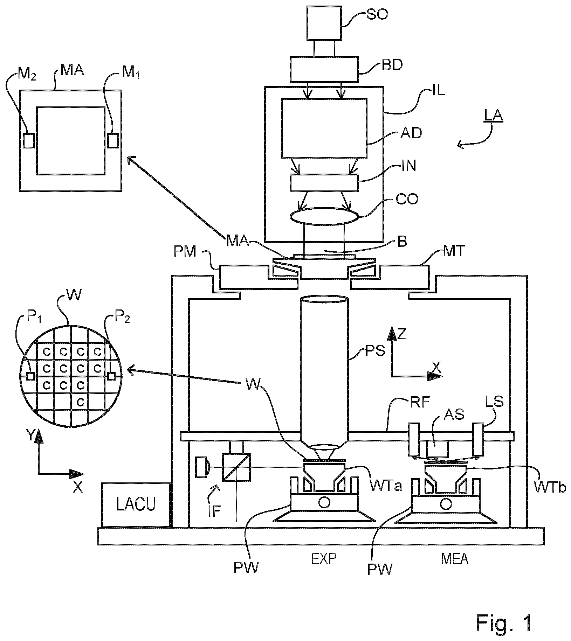

Figure 1 schematically depicts a lithographic apparatus LA. The apparatus includes an illumination system (illuminator) IL configured to condition a radiation beam B (e.g., UV radiation or DUV radiation), a patterning device support or support structure (e.g., a mask table) MT constructed to support a patterning device (e.g., a mask) MA and connected to a first positioner PM configured to accurately position the patterning device in accordance with certain parameters; two substrate tables (e.g., a wafer table) WTa and WTb each constructed to hold a substrate (e.g., a resist coated wafer) W and each connected to a second positioner PW configured to accurately position the substrate in accordance with certain parameters; and a projection system (e.g., a refractive projection lens system) PS configured to project a pattern imparted to the radiation beam B by patterning device MA onto a target portion C (e.g., including one or more dies) of the substrate W. A reference frame RF connects the various components, and serves as a reference for setting and measuring positions of the patterning device and substrate and of features on them.

The illumination system may include various types of optical components, such as refractive, reflective, magnetic, electromagnetic, electrostatic or other types of optical components, or any combination thereof, for directing, shaping, or controlling radiation.

The patterning device support MT holds the patterning device in a manner that depends on the orientation of the patterning device, the design of the lithographic apparatus, and other conditions, such as for example whether or not the patterning device is held in a vacuum environment. The patterning device support can use mechanical, vacuum, electrostatic or other clamping techniques to hold the patterning device. The patterning device support MT may be a frame or a table, for example, which may be fixed or movable as required. The patterning device support may ensure that the patterning device is at a desired position, for example with respect to the projection system.

The term "patterning device" used herein should be broadly interpreted as referring to any device that can be used to impart a radiation beam with a pattern in its cross-section such as to create a pattern in a target portion of the substrate. It should be noted that the pattern imparted to the radiation beam may not exactly correspond to the desired pattern in the target portion of the substrate, for example if the pattern includes phase-shifting features or so called assist features. Generally, the pattern imparted to the radiation beam will correspond to a particular functional layer in a device being created in the target portion, such as an integrated circuit.

As here depicted, the apparatus is of a transmissive type (e.g., employing a transmissive patterning device). Alternatively, the apparatus may be of a reflective type (e.g., employing a programmable mirror array of a type as referred to above, or employing a reflective mask). Examples of patterning devices include masks, programmable mirror arrays, and programmable LCD panels. Any use of the terms "reticle" or "mask" herein may be considered synonymous with the more general term "patterning device." The term "patterning device" can also be interpreted as referring to a device storing in digital form pattern information for use in controlling such a programmable patterning device.

The term "projection system" used herein should be broadly interpreted as encompassing any type of projection system, including refractive, reflective, catadioptric, magnetic, electromagnetic and electrostatic optical systems, or any combination thereof, as appropriate for the exposure radiation being used, or for other factors such as the use of an immersion liquid or the use of a vacuum. Any use of the term "projection lens" herein may be considered as synonymous with the more general term "projection system".

The lithographic apparatus may also be of a type wherein at least a portion of the substrate may be covered by a liquid having a relatively high refractive index, e.g., water, so as to fill a space between the projection system and the substrate. An immersion liquid may also be applied to other spaces in the lithographic apparatus, for example, between the mask and the projection system. Immersion techniques are well known in the art for increasing the numerical aperture of projection systems.

In operation, the illuminator IL receives a radiation beam from a radiation source SO. The source and the lithographic apparatus may be separate entities, for example when the source is an excimer laser. In such cases, the source is not considered to form part of the lithographic apparatus and the radiation beam is passed from the source SO to the illuminator IL with the aid of a beam delivery system BD including, for example, suitable directing mirrors and/or a beam expander. In other cases the source may be an integral part of the lithographic apparatus, for example when the source is a mercury lamp. The source SO and the illuminator IL, together with the beam delivery system BD if required, may be referred to as a radiation system.

The illuminator IL may for example include an adjuster AD for adjusting the angular intensity distribution of the radiation beam, an integrator IN and a condenser CO. The illuminator may be used to condition the radiation beam, to have a desired uniformity and intensity distribution in its cross section.

The radiation beam B is incident on the patterning device MA, which is held on the patterning device support MT, and is patterned by the patterning device. Having traversed the patterning device (e.g., mask) MA, the radiation beam B passes through the projection system PS, which focuses the beam onto a target portion C of the substrate W. With the aid of the second positioner PW and position sensor IF (e.g., an interferometric device, linear encoder, 2-D encoder or capacitive sensor), the substrate table Wta or WTb can be moved accurately, e.g., so as to position different target portions C in the path of the radiation beam B. Similarly, the first positioner PM and another position sensor (which is not explicitly depicted in Figure 1) can be used to accurately position the patterning device (e.g., mask) MA with respect to the path of the radiation beam B, e.g., after mechanical retrieval from a mask library, or during a scan.

Patterning device (e.g., mask) MA and substrate W may be aligned using mask alignment marks M1, M2 and substrate alignment marks P1, P2. Although the substrate alignment marks as illustrated occupy dedicated target portions, they may be located in spaces between target portions (these are known as scribe-lane alignment marks). Similarly, in situations in which more than one die is provided on the patterning device (e.g., mask) MA, the mask alignment marks may be located between the dies. Small alignment marks may also be included within dies, in amongst the device features, in which case it is desirable that the markers be as small as possible and not require any different imaging or process conditions than adjacent features. The alignment system, which detects the alignment markers is described further below.

The depicted apparatus could be used in a variety of modes. In a scan mode, the patterning device support (e.g., mask table) MT and the substrate table WT are scanned synchronously while a pattern imparted to the radiation beam is projected onto a target portion C (i.e., a single dynamic exposure). The speed and direction of the substrate table WT relative to the patterning device support (e.g., mask table) MT may be determined by the (de-)magnification and image reversal characteristics of the projection system PS. In scan mode, the maximum size of the exposure field limits the width (in the non-scanning direction) of the target portion in a single dynamic exposure, whereas the length of the scanning motion determines the height (in the scanning direction) of the target portion. Other types of lithographic apparatus and modes of operation are possible, as is well-known in the art. For example, a step mode is known. In so-called "maskless" lithography, a programmable patterning device is held stationary but with a changing pattern, and the substrate table WT is moved or scanned.

Combinations and/or variations on the above described modes of use or entirely different modes of use may also be employed.

Lithographic apparatus LA is of a so-called dual stage type which has two substrate tables Wta, WTb and two stations - an exposure station EXP and a measurement station MEA - between which the substrate tables can be exchanged. While one substrate on one substrate table is being exposed at the exposure station, another substrate can be loaded onto the other substrate table at the measurement station and various preparatory steps carried out. This enables a substantial increase in the throughput of the apparatus. The preparatory steps may include mapping the surface height contours of the substrate using a level sensor LS and measuring the position of alignment markers on the substrate using an alignment sensor AS. If the position sensor IF is not capable of measuring the position of the substrate table while it is at the measurement station as well as at the exposure station, a second position sensor may be provided to enable the positions of the substrate table to be tracked at both stations, relative to reference frame RF. Other arrangements are known and usable instead of the dual-stage arrangement shown. For example, other lithographic apparatuses are known in which a substrate table and a measurement table are provided. These are docked together when performing preparatory measurements, and then undocked while the substrate table undergoes exposure.

The apparatus further includes a lithographic apparatus control unit LACU which controls all the movements and measurements of the various actuators and sensors described. LACU also includes signal processing and data processing capacity to implement desired calculations relevant to the operation of the apparatus. In practice, control unit LACU will be realized as a system of many subunits, each handling the real-time data acquisition, processing and control of a subsystem or component within the apparatus. For example, one processing subsystem may be dedicated to servo control of the substrate positioner PW. Separate units may even handle coarse and fine actuators, or different axes. Another unit might be dedicated to the readout of the position sensor IF. Overall control of the apparatus may be controlled by a central processing unit, communicating with these sub-systems processing units, with operators and with other apparatuses involved in the lithographic manufacturing process.

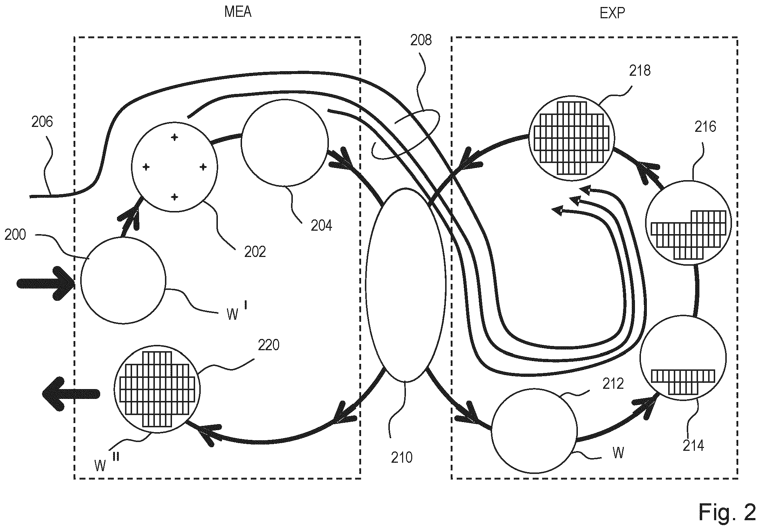

Figure 2 illustrates the steps to expose target portions (e.g. dies) on a substrate W in the dual stage apparatus of Figure 1. On the left hand side within a dotted box are steps performed at a measurement station MEA, while the right hand side shows steps performed at the exposure station EXP. From time to time, one of the substrate tables Wta, WTb will be at the exposure station, while the other is at the measurement station, as described above. For the purposes of this description, it is assumed that a substrate W has already been loaded into the exposure station. At step 200, a new substrate W' is loaded to the apparatus by a mechanism not shown. These two substrates are processed in parallel in order to increase the throughput of the lithographic apparatus.

Referring initially to the newly-loaded substrate W', this may be a previously unprocessed substrate, prepared with a new photo resist for first time exposure in the apparatus. In general, however, the lithography process described will be merely one step in a series of exposure and processing steps, so that substrate W' has been through this apparatus and/or other lithography apparatuses, several times already, and may have subsequent processes to undergo as well. Particularly for the problem of improving overlay performance, the task is to ensure that new patterns are applied in exactly the correct position on a substrate that has already been subjected to one or more cycles of patterning and processing. These processing steps progressively introduce distortions in the substrate that must be measured and corrected for, to achieve satisfactory overlay performance.

The previous and/or subsequent patterning step may be performed in other lithography apparatuses, as just mentioned, and may even be performed in different types of lithography apparatus. For example, some layers in the device manufacturing process which are very demanding in parameters such as resolution and overlay may be performed in a more advanced lithography tool than other layers that are less demanding. Therefore some layers may be exposed in an immersion type lithography tool, while others are exposed in a 'dry' tool. Some layers may be exposed in a tool working at DUV wavelengths, while others are exposed using EUV wavelength radiation.

At 202, alignment measurements using the substrate marks P1 etc. and image sensors (not shown) are used to measure and record alignment of the substrate relative to substrate table Wta/WTb. In addition, several alignment marks across the substrate W' will be measured using alignment sensor AS. These measurements are used in one embodiment to establish a "wafer grid", which maps very accurately the distribution of marks across the substrate, including any distortion relative to a nominal rectangular grid.

At step 204, a map of wafer height (Z) against X-Y position is measured also using the level sensor LS. Conventionally, the height map is used only to achieve accurate focusing of the exposed pattern. It may be used for other purposes in addition.

When substrate W' was loaded, recipe data 206 were received, defining the exposures to be performed, and also properties of the wafer and the patterns previously made and to be made upon it. To these recipe data are added the measurements of wafer position, wafer grid and height map that were made at 202, 204, so that a complete set of recipe and measurement data 208 can be passed to the exposure station EXP. The measurements of alignment data for example comprise X and Y positions of alignment targets formed in a fixed or nominally fixed relationship to the product patterns that are the product of the lithographic process. These alignment data, taken just before exposure, are used to generate an alignment model with parameters that fit the model to the data. These parameters and the alignment model will be used during the exposure operation to correct positions of patterns applied in the current lithographic step. The model in use interpolates positional deviations between the measured positions. A conventional alignment model might comprise four, five or six parameters, together defining translation, rotation and scaling of the 'ideal' grid, in different dimensions. Advanced models are known that use more parameters.

At 210, wafers W' and W are swapped, so that the measured substrate W' becomes the substrate W entering the exposure station EXP. In the example apparatus of Figure 1, this swapping is performed by exchanging the supports Wta and WTb within the apparatus, so that the substrates W, W' remain accurately clamped and positioned on those supports, to preserve relative alignment between the substrate tables and substrates themselves. Accordingly, once the tables have been swapped, determining the relative position between projection system PS and substrate table WTb (formerly Wta) is all that is necessary to make use of the measurement information 202, 204 for the substrate W (formerly W') in control of the exposure steps. At step 212, reticle alignment is performed using the mask alignment marks M1, M2. In steps 214, 216, 218, scanning motions and radiation pulses are applied at successive target locations across the substrate W, in order to complete the exposure of a number of patterns.

By using the alignment data and height map obtained at the measuring station in the performance of the exposure steps, these patterns are accurately aligned with respect to the desired locations, and, in particular, with respect to features previously laid down on the same substrate. The exposed substrate, now labeled W" is unloaded from the apparatus at step 220, to undergo etching or other processes, in accordance with the exposed pattern.

The skilled person will know that the above description is a simplified overview of a number of very detailed steps involved in one example of a real manufacturing situation. For example rather than measuring alignment in a single pass, often there will be separate phases of coarse and fine measurement, using the same or different marks. The coarse and/or fine alignment measurement steps can be performed before or after the height measurement, or interleaved.

In the flow of Figure 2, on the measurement side, the wafer alignment data measured at step 202 and the wafer height/leveling data measured at step 204 are both measured with respect to a reference arrangement or fiducial. For example, the fiducial may comprise a fiducial sensor on a wafer stage or chuck (more generally a substrate support) and a plurality of reference structures (e.g., a set of marks), comprising respectively one or more reference structures or marks on the substrate support and one or more reference structures or marks on the reticle and/or reticle stage.

On the measurement side, an alignment sensor and/or leveling sensor illuminates the one or more substrate support marks on the fiducial surface during alignment and leveling. As a result, the aligned wafer position in the wafer plane is described with respect to the fiducial by the wafer alignment data (measurements of alignment structures or marks on the wafer) and/or the wafer position in the direction perpendicular to the wafer plane is described with respect to the fiducial by the leveling data. Typically more than one mark is measured on the fiducial, enabling the shape, and therefore any drift in this shape over time, of the fiducial surface to be characterized or modeled. This may be done using alignment modeling techniques, e.g., to measure and model an aligned position deviation (APD) with respect to nominal or expected positions of each mark assuming a perfectly flat surface.

On the exposure side, the reticle alignment step of step 212 aligns the reticle with respect to the fiducial. This may be achieved by using the fiducial sensor on the fiducial to measure illumination (e.g., from the exposure source) via one or more reference structures or marks on the reticle and/or reticle stage. In addition to reticle stage positioning, other corrections may be performed at the expose side, e.g., lens corrections based on lens aberration measurements (wavefront measurements) which may also be performed by the fiducial sensor.

In performing these measurement steps 202, 204, 212, each with respect to the fiducial, the position of the reticle with respect to the wafer can be determined.

The exposure side metrology uses the measurement side metrology as a baseline and assumes that the measurements are correct. For example, the exposure side will correct exposure side measurements and/or models (e.g., for reticle shape and/or lens aberrations) based on the fiducial surface shape measured on the measurement side.

An initial calibration step, sometimes referred to as measurement-to-exposure matching, is typically performed during set-up of the lithographic apparatus. Simplistically, this matching is done using "stage alignment" measurements in measurement side, and "reticle alignment" measurements on the exposure side. This matching calibrates any difference between the exposure side fiducial metrology to the measurement side fiducial metrology due to the different methods used at each side. During production, the fiducial is subject to temporal drift. As such, the measurement side metrology is performed routinely on the fiducial to characterize/model this drift. In this manner, any changes to the fiducial over time will be taken into account at the exposure side. However, monitoring of this drift works under the assumption that the measured fiducial will be seen the same on the measurement side and exposure side, such that the same temporal fiducial position drift is captured.

However, because the measurement methods and measured structures on each side differ this is not always the case, and differences in the measured drift will be detected on each side in practice. In particular, because only the measurement side measures (marks on) the surface of the fiducial, rather than using cameras/detectors within the fiducial, anything which degrades this surface and/or the marks thereon will be detected only on the measurement side. Such degradation includes degradation of the marks themselves and/or of the fiducial coating.

The measured fiducial position drift comprises two main components: a plate deformation drift component which is a measure of the actual position drift that results from fiducial plate deformation and change in shape, and a fiducial degradation drift component which describes an erroneous position shift; i.e., a shift seen by the detector, but not actually present, which results only from a deterioration of the fiducial marks.

Once the measurement side metrology is modeled, the modeled data will comprise both of the wanted plate deformation drift component describing the fiducial surface shape and the additional fiducial degradation drift component (a nuisance component). On the expose side, this additional fiducial degradation drift component will not be measured, only the main component. The expose side control will therefore incorrectly assume that this additional nuisance component has resulted from expose side error (e.g., reticle, lens and/or reticle stage error) and determine erroneous corrections for this (e.g., via reticle, lens and/or reticle stage control/actuation). These erroneous "corrections" will be directly responsible for imaging errors in the final product.

To address this issue, a method for detecting the presence and/or amount of fiducial degradation is desirable. Such a fiducial degradation metric may enable decisions to be made on when to perform maintenance actions (e.g., a fiducial swap). Alternatively or in addition, such a fiducial degradation metric may be used to determine inline corrections for the fiducial degradation. The fiducial degradation metric may comprise a determination of the aforementioned fiducial degradation drift component of the measured fiducial position drift.

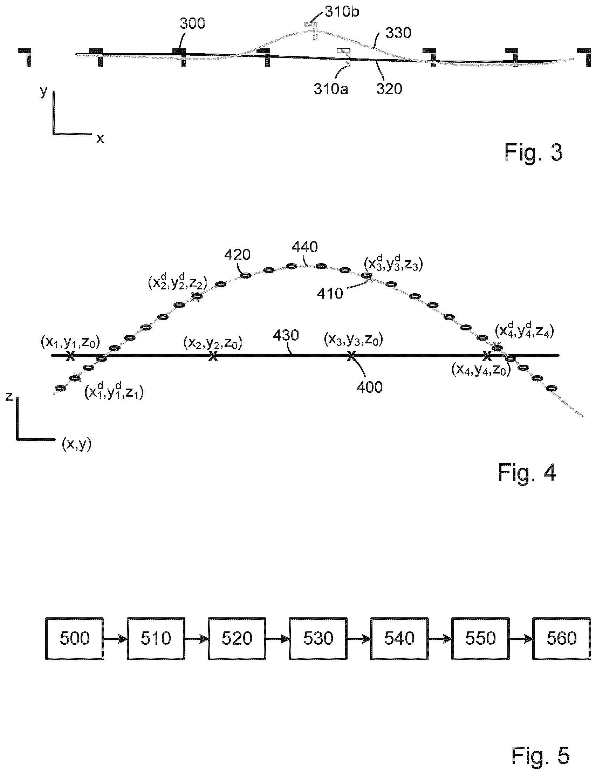

Figure 3 is a simplified schematic representation of reference structures or fiducial alignment marks 300 on a fiducial plate, illustrating the issue of fiducial degradation (in an exaggerated example). In this purely illustrative example, one specific mark 310a is particularly impacted by fiducial degradation, the other marks not being significantly affected). The actual position 310a is not measured by the detector, instead the detector perceives or measures this mark at an erroneous position 310b. The difference between the actual position 310a and erroneous position 310b is due to the fiducial degradation drift component. When the plate shape is modeled for basing a correction on, the modeled shape will comprise the gray line 330 (a modeled shape obtained from a plate shape modeling step), rather than the actual shape denoted by the black line 320. Such degraded marks and the apparent drift in their position result in an incorrect modeled shape and incorrect corrections, with a consequence of reduced accuracy and precision for a parameter of interest such as overlay, for example.

To inspect the reference mark on the sensor so as to characterize this fiducial degradation, several methods have been developed, each with their own drawback. One such method is based on the determination of a multi-correlation coefficient (MCC), which is a measure of the signal to noise ratio of the mark's response. Such a parameter may be used to a metric of the mark's health (i.e., a fiducial degradation metric). However, while the MCC metric is generally useful, there are limitations on how accurately such a metric captures mark degradation, and it has been observed that the MCC metric does not always correlate with on-product overlay (OPO) impact.

Another method is based on reconstructing an image of the mark. However, this requires a full and dense scan using the alignment laser which considerably reduces the lifetime of the mark, as well as comprising a dedicated measurement which impacts availability of the system in general. Moreover, the image obtained is of low resolution, making the interpretation often subjective and requiring non-negligible time for analysis.

Another method compares a difference of the measurement results of stage align measurement results obtained from different subsets of alignment marks. Any deviation could provide indication of an individual mark degradation. However, a limitation of this method is that it loses sensitivity if multiple marks are degrading simultaneously.

As such, present methods are generally unable to provide a clear metric that the mark is degraded. This means that there may be a considerable OPO impact despite the present diagnostic methods indicating that the mark is not degraded. Moreover, the image reconstruction technique requires system downtime and results in a reduced mark lifetime.

Furthermore, none of the current methods assess the degradation and/or its impact quantitatively, meaning that they cannot be used for inline correction. Without inline correction, the error propagates into the process control loop which will introduce a "Wafer in Process (WIP) Impact" upon moving to redundant marks on the plate or a plate swap. One or more redundant sets of marks may be provided on a plate such that the system can switch to measuring the redundant set when the first set are degraded, postponing the need for a plate swap. A WIP impact is an impact on partially completed substrates/wafers having had some but not all layers exposed thereon. The difference in condition between the replacement/reconditioned part before and after replacement/reconditioning means that the control loop has to be reset, resulting in mismatch issues between layers exposed on the wafer before and after replacement/reconditioning.

It is therefore proposed to combine alignment sensor measurements, i.e., x, y plane or fiducial plane position data, with level sensor measurements, i.e., height metrology data or z-metrology data. The x, y plane or fiducial plane in the context of this disclosure may describe any plane parallel to the fiducial surface (e.g., which may be parallel to a substrate surface (when loaded) or substrate table surface in some contexts). The z direction is perpendicular to the, y plane or fiducial plane. The proposed method may be used on any fiducial or any sensor reference (e.g., inter alia transmission image sensor, wavefront sensor, level sensor, alignment sensor) to detect and/or quantify fiducial plate (e.g., reference mark) degradation.

The inventors have appreciated that the measurement error is a combination of an error component resultant from degradation of the mark and an error component resultant from deformation of the plate surface on which the mark resides. The fiducial plate surface deforms (in the z direction) because of, for example, temperature fluctuations.

It is therefore proposed to use height metrology data (e.g., as measured using a level sensor), which describes the shape of the fiducial plate in the z-direction, to calculate the plate deformation drift component of the fiducial plane position data, i.e., the drift in position of the reference marks due (substantially) to the plate deformation. This plate deformation drift component data can then be used to isolate the fiducial degradation drift component from the fiducial plane position data to provide a fiducial degradation metric. For example, the plate deformation drift component data may be subtracted from measured fiducial position drift data determined from the measured fiducial plane position data to yield the fiducial degradation drift component.

The method comprises determining first fiducial position drift data from fiducial plane position data (e.g., alignment sensor data). This first fiducial position drift data comprises contributions from both the mark degradation and plate shape deformation (i.e., the plate deformation drift component of the fiducial position drift and the fiducial degradation drift component of the fiducial position drift). The method also comprises determining second fiducial position drift data from height metrology data (e.g., level sensor data). This second fiducial position drift data is not affected by mark degradation and so substantially comprises only, and therefore is substantially equal to, the plate deformation drift component. The difference of the first fiducial position drift data and second fiducial position drift data will therefore yield the fiducial degradation drift component or fiducial degradation metric.

The fiducial degradation metric (fiducial degradation drift component) can then be used to reduce or prevent OPO impact; e.g., by determining when to replace the plate or swap to a redundant set of marks and/or to determine inline corrections. Such inline corrections may reduce any WIP impact of a swap, improve overlay performance generally and/or potentially enable the lifetime of the mark/plate to be extended (if its degradation can be corrected for, the mark potentially can be used for longer), increasing system availability.

Figure 4 schematically illustrates the location of the reference marks without plate deformation (black crosses) 400 and with plate deformation (gray crosses) 410 on a plot of height z against the fiducial plane directions (x, y). Also shown are height datapoints 420. Without plate deformation, all marks 400, are at the same height z0 430, i.e., the plate is perfectly flat. Due to the plate deformation indicated by height data 420 and fitted model thereto 440, the location of the marks 410 are shifted in both height (to z1, z2, z3, z4 respectively and in their x, y positions (indicated by superscript d).

Figure 5 is a flowchart describing a method according to the concepts described herein. At step 500, fiducial plane position data over time $R_i(t) = [x_i(t), y_i(t)]$, with $i = 1, ..., N$ and $N$ is the number of measurements (number of marks measured) is obtained. This may be achieved by using an alignment sensor to periodically measure the reference marks or fiducial marks on the fiducial surface.

At step 510, the fiducial plane position data over time may be used to determine first fiducial position drift data $\Delta R_i^{1st}$. This may comprise determining the difference in the fiducial plane position data between two (e.g., consecutive) time instances $\Delta R_i^{1st} = R_i(t_n) - R_i(t_{n-1})$ where $n$ is the measurement time index. This obtains an estimate of changes over time (drift) of the fiducial position data due to degradation and shape deformation. Individually, the $\Delta R_i^{1st} = [\Delta x_i^{1st}, \Delta y_i^{1st}]$ values provide an estimate of the drift over time at the measured location i.

It can be appreciated that, as the alignment mark measurements are affected by degradation, this measured drift into two contributions:

$\Delta R_i^{1st} = \Delta R_i^{PD} + \Delta R_i^{FD}$, where $\Delta R_i^{PD}$ is the plate deformation drift component of the fiducial position drift and $\Delta R_i^{FD}$ is the fiducial degradation drift component (e.g., mark degradation drift) of the fiducial position drift.

The first fiducial position drift data $\Delta R_i^{1st}$ may be combined for all mark locations, $\Delta R = (\Delta R_1, ..., \Delta R_N)$ and a suitable model (first model) fitted to these datapoints so to determine a profile of the fiducial plate surface horizontal deformation over time. The first model may comprise any suitable function, ranging from a basic polynomial function which describes the deformation around the x and y axes independently to more complex functions which include cross terms or an explicit model of the expected sensor deformation.

At step 520, height data $z_k(t)$ (height map data) over time for the fiducial surface is obtained, where k is the measurement location index. The height data may be obtained for each of the same mark locations as measured by the alignment sensor at step 500 (although this is not necessary), and at additional intermediate locations. Optionally, the height data may also be obtained along two or more y-lanes. Alignment marks are typically located at same y=0 location, and distributed along the x axis. Measuring at different locations is possible as the level sensor does not require a mark for its measurement, but simply a reflective surface. However, the number of measurements and their location may vary from these examples and all that is important is that the fiducial plane position data and height metrology data relate to a common surface area (i.e., the fiducial surface). The choice of the measurement locations $z_k(t)$ of course depends on a desired accuracy and complexity of the sensor modeling.

At step 530, as with the fiducial plane position data, the height drift may be characterized by determining the difference in height metrology data between two (e.g., consecutive) time instances $\Delta z_k = z_k(t_n) - z_k(t_{n-1})$ where $n$ is the measurement time index.

The height drift data $\Delta z_k$ may be combined for all mark locations, $\Delta Z = (\Delta z_1, ..., \Delta z_M)$ where M is the total number of measurement points and optionally a suitable model fitted to these datapoints so to determine a profile of the fiducial surface vertical deformation over time.

At step 540, the fiducial plane deformation of the sensor surface $\Delta R^z = (\Delta R_1^z, ..., \Delta R_M^z)$ (a second model) may be deduced from the profile $\Delta Z$ of the fiducial surface vertical deformation over time determined in the previous step. This step may use any suitable second model (e.g., a physical mechanical model), such as a simple "projection" of the z-height map over the x,y fiducial plane, or more complex models representing the specific details or constraints of the actual fiducial design and performance.

At step 550, second fiducial position drift data

$$\Delta R_i^{2nd} = [\Delta x_i^{2nd}, \Delta y_i^{2nd}]$$ is determined for each of the reference mark positions measured to obtain the fiducial plane position data. As this second fiducial position drift data has been obtained from level sensor data, it is not affected by mark degradation and therefore substantially equals the plate deformation drift component:

$$\Delta R_i^{2nd} = \Delta R_i^{PD}.$$

At step 560, the fiducial degradation metric (i.e., the fiducial degradation drift component $\Delta R_i^{FD}$) may be obtained as the difference of the first fiducial position drift data and second fiducial position drift data $$\Delta R_i^{FD} = \Delta R_i^{1st} - \Delta R_i^{2nd}.$$ Note that the fiducial degradation metric here is determined per each individual mark, and therefore the health of each mark can be individually assessed and/or quantified.

It can be appreciated that the first fiducial position drift data $\Delta R_i^{1st}$ at step 560 may comprise the raw first fiducial position drift data $\Delta R_i^{1st}$ (i.e., without or prior to first model fitted), in which case the first modeling sub-step is not required for the concepts disclosed herein, or alternatively it may comprise modeled first fiducial position drift data $\Delta R_i^{1st}$ as assessed/determined from the first model (i.e., assessed at the mark locations in the same way as the second model is assessed to obtain the second fiducial position drift data $\Delta R_i^{2nd}$). The latter approach therefore comprises comparing (assessed values from) a first model of the horizontal fiducial surface obtained by a model fitting to alignment data and (equivalent assessed values from) a second model of the horizontal fiducial surface obtained by a model fitting to leveling data. This may provide a better accuracy, being based on more data, and allowing for better consistency checks with the actual physical model (as it describes the whole surface).

The proposed methods provide an additional performance indicator for detecting apparent drifts (caused by mark degradation) in stage alignment marks and/or marks of any other sensor fiducial. This may enable the probability of a false detection of a mark degradation induced drift to be reduced (e.g., in combination with other performance indicators or fiducial degradation metrics such as those described). Because the metric described herein is a per-mark metric, this method clearly identifies which mark is degraded (which is not possible with present methods). This enables data from a particularly degraded mark to be ignored or weighted less, for example. Furthermore, by identifying the actual component of the drift caused by degradation (and not actual mechanical drift), it simplifies the exercise of defining control limits or threshold for e.g. swaps or other maintenance actions.

The proposed methods provide an enhanced and physics-robust plate shape modeling technique which provides for a selective filtering of non-physical plate deformation caused by incorrect alignment readouts due to degraded marks.

The proposed methods provide a quantitative estimate of drift due to degradation, enabling inline correction, and thus lifetime extension.

The method can be combined with existing methods to improve the overall reliability of the prediction of the degradation.

The concepts disclosed herein may be applicable to a sensor for aligning a first object support (e.g., reticle support or reticle stage) to a second object support (e.g., substrate support or substrate stage). By way of a specific example, the sensor may be used to perform such alignment in a two-stage exposure apparatus or lithographic apparatus, whereby a substrate support is introduced to an exposure side after metrology on a measurement side and aligned with a reticle support. However, the concepts are not so limited and may apply to such a sensor in a single stage exposure apparatus and/or any sensor, metrology or inspection device comprising a fiducial or reference plate subject to degradation, and which is subject to fiducial surface plane metrology and height metrology.

Where applicable, steps of the methods described and claimed herein may be implemented as program instructions forming a computer program which is able to carry out the invention when performed in a suitable apparatus, e.g., a stand-alone processing device and/or a processing device integrated within any of the sensor apparatuses, exposure apparatuses, metrology apparatuses or inspection apparatuses described herein (e.g., the lithographic apparatus control unit LACU in Figure 1). The computer program may be stored on any non-transitory medium internal or external to such apparatuses.

While specific embodiments of the invention have been described above, it will be appreciated that the invention may be practiced otherwise than as described.

Although specific reference may have been made above to the use of embodiments of the invention in the context of optical lithography, it will be appreciated that the invention may be used in other applications, for example imprint lithography, and where the context allows, is not limited to optical lithography. In imprint lithography a topography in a patterning device defines the pattern created on a substrate. The topography of the patterning device may be pressed into a layer of resist supplied to the substrate whereupon the resist is cured by applying electromagnetic radiation, heat, pressure or a combination thereof. The patterning device is moved out of the resist leaving a pattern in it after the resist is cured.

The terms "radiation" and "beam" used herein encompass all types of electromagnetic radiation, including ultraviolet (UV) radiation (e.g., having a wavelength of or about 365, 355, 248, 193, 157 or 126 nm) and extreme ultra-violet (EUV) radiation (e.g., having a wavelength in the range of 1-100 nm), as well as particle beams, such as ion beams or electron beams.

The term "lens", where the context allows, may refer to any one or combination of various types of optical components, including refractive, reflective, magnetic, electromagnetic and electrostatic optical components. Reflective components are likely to be used in an apparatus operating in the UV and/or EUV ranges.

The breadth and scope of the present invention should not be limited by any of the above-described exemplary embodiments, but should be defined only in accordance with the following claims and their equivalents.

## Claims

1. A method of determining a fiducial degradation metric for a sensor fiducial, the method comprising:

   obtaining fiducial plane position data describing a position over a time period, and in a fiducial plane, of a plurality of marks on a fiducial surface;
   determining first fiducial position drift data from the fiducial plane position data, said first fiducial position drift data describing a temporal drift in measured positions within the fiducial plane position data;
   obtaining height data describing a position over said time period, and perpendicular to the fiducial plane, of the fiducial surface;
   determining second fiducial position drift data from said height data; and
   determining the fiducial degradation metric from said first fiducial position drift data and said second fiducial position drift data.

2. A method as claimed in claim 1, wherein said determining second fiducial position drift data comprises:

   determining, from said height data, height drift data describing a temporal drift in the position, perpendicular to the fiducial plane, of the fiducial surface; and
   determining said second fiducial position drift data from said height drift data.

3. A method as claimed in claim 2, wherein said determining second fiducial position drift data from said height drift data comprises applying a second model to said height drift data which translates position drift perpendicular to the fiducial plane to position drift in said fiducial plane.

4. A method as claimed in claim 2 or 3, wherein determining height drift data comprises determining a difference in said height data between two time instances within said time period.

5. A method as claimed in any preceding claim, wherein said determining the fiducial degradation metric comprises determining the fiducial degradation metric from a difference of said first fiducial position drift data and said second fiducial position drift data.

6. A method as claimed in any preceding claim, wherein said fiducial degradation metric, said first fiducial position drift data and said second fiducial position drift data is determined per mark of said plurality of marks.

7. A method as claimed in claim 6, comprising using the fiducial degradation metric to individually monitor a degradation state of each mark.

8. A method as claimed in any preceding claim, comprising determining an inline correction for fiducial degradation from said fiducial degradation metric.

9. A method as claimed in any preceding claim, comprising using said fiducial degradation metric to determine whether to perform a maintenance action on the fiducial or to switch to measuring a redundant set of marks on the fiducial.

10. A method as claimed in any preceding claim, wherein said fiducial degradation metric is a fiducial degradation drift component of said first fiducial position drift data.

11. A method as claimed in any preceding claim, wherein determining first fiducial position drift data comprises determining a difference in said fiducial plane position data between two time instances of said time period.

12. A method as claimed in any preceding claim, wherein said fiducial plane position data comprises alignment sensor data.

13. A method as claimed in any preceding claim, wherein said first fiducial position drift data used in the step of determining the fiducial degradation metric comprises modeled first fiducial position drift data, the method comprising the steps of:

   fitting a model to raw first fiducial position drift data determined from said fiducial plane position data; and.
   determining said modeled first fiducial position drift data from the first model.

**14.** A method as claimed in any preceding claim, comprising measuring said fiducial surface using a level sensor to obtain said height data.

**15.** A method as claimed in any preceding claim, comprising measuring said marks using an alignment sensor to obtain said fiducial plane position data.

**16.** A method as claimed in any preceding claim, wherein said height data comprises level sensor data.

**17.** A method as claimed in any preceding claim, wherein the sensor fiducial is comprised within a sensor, exposure apparatus, lithographic apparatus, inspection apparatus or metrology apparatus.

**18.** A computer program comprising program instructions operable to perform the method of any of claims 1 to 17, when run on a suitable apparatus.

**19.** A non-transient computer program carrier comprising the computer program of claim 17.

**20.** A processing system comprising a processor and a storage device comprising the computer program of claim 18.

**21.** A metrology, inspection and/or sensor apparatus comprising the processing system of claim 20.

**22.** A metrology, inspection and/or sensor apparatus as claimed in claim 21, comprising an transmission image sensor, wavefront sensor, level sensor, an alignment sensor and/or a sensor for aligning a first object support to a second object support.

**23.** An exposure apparatus comprising the processing system of claim 20.

**24.** An exposure apparatus comprising the metrology, inspection and/or sensor apparatus of claim 21 or 22.

**25.** An exposure apparatus as claimed in claim 24, further comprising:

  a patterning device support for supporting a patterning device;
  projection optics for projecting a pattern onto the patterning device; and
  at least one substrate support for supporting the substrate.

Fig. 1

Fig. 2

Fig. 3

Fig. 4

Fig. 5

**EUROPEAN SEARCH REPORT**

Application Number

EP 24 17 9978

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | "METHOD OF MONITORING AN EXPOSURE PROCESS", RESEARCH DISCLOSURE, KENNETH MASON PUBLICATIONS, HAMPSHIRE, UK, GB , vol. 720, no. 10 28 February 2024 (2024-02-28), XP007152423, ISSN: 0374-4353 Retrieved from the Internet: URL:https://www.researchdisclosure.com/database/RD720010 [retrieved on 2024-02-28] * paragraph [0057] - paragraph [0078] * * figure 7 * ----- | 1-15 | INV. G03F7/00 G03F9/00 |
| A | "METHOD OF DETERMINING DEGRADATION ON A LITHOGRAPHIC APPARATUS", RESEARCH DISCLOSURE, KENNETH MASON PUBLICATIONS, HAMPSHIRE, UK, GB , vol. 712, no. 15 28 June 2023 (2023-06-28), XP007151518, ISSN: 0374-4353 Retrieved from the Internet: URL:https://www.researchdisclosure.com/database/RD712015 [retrieved on 2023-06-28] * paragraph [0048] - paragraph [0051] * * figure 3 * ----- | 1-15 | TECHNICAL FIELDS SEARCHED (IPC) G03F |

The present search report has been drawn up for all claims

| Place of search | Date of completion of the search | Examiner |
|---|---|---|
| Munich | 7 February 2025 | Meixner, Matthias |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons
...........................................................................
& : member of the same patent family, corresponding
    document

EPO FORM 1503 03.82 (P04C01)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2006033921 A1
- US 2010201963 A1
- US 2006066855 A1
- WO 2009078708 A
- WO 2009106279 A
- US 20110027704 A
- US 20110043791 A
- US 2011102753 A1
- US 20120044470 A
- US 20120123581 A
- US 20130258310 A
- US 20130271740 A
- WO 2013178422 A1